(19) Europäisches Patentamt
European Patent Office
Office européen des brevets

(11) **EP 4 202 372 B1**

(12) **EUROPÄISCHE PATENTSCHRIFT**

(45) Veröffentlichungstag und Bekanntmachung des Hinweises auf die Patenterteilung:
**06.12.2023   Patentblatt 2023/49**

(21) Anmeldenummer: **21216646.6**

(22) Anmeldetag: **21.12.2021**

(51) Internationale Patentklassifikation (IPC):
**G01D 3/02** *(2006.01)*      **G01D 5/24** *(2006.01)*

(52) Gemeinsame Patentklassifikation (CPC):
**G01D 5/24; G01D 3/02**

(54) **VERFAHREN ZUM FILTERN EINES SENSORSIGNALS UND VORRICHTUNG ZUM ANSTEUERN EINES AKTUATORS MITTELS FILTERUNG EINES SENSORSIGNALS**

METHOD FOR FILTERING A SENSOR SIGNAL AND DEVICE FOR DRIVING AN ACTUATOR BY FILTERING A SENSOR SIGNAL

PROCÉDÉ DE FILTRAGE D'UN SIGNAL DE CAPTEUR ET DISPOSITIF DE COMMANDE D'UN ACTIONNEUR PAR FILTRAGE D'UN SIGNAL DE CAPTEUR

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**28.06.2023   Patentblatt 2023/26**

(73) Patentinhaber: **Euroimmun Medizinische Labordiagnostika AG 23560 Lübeck (DE)**

(72) Erfinder:
• **AHLBORG, Felix**
  **23560 Lübeck (DE)**
• **VON DRATHEN, Arne**
  **23560 Lübeck (DE)**
• **WESSEL, Siegfried**
  **23560 Lübeck (DE)**

(56) Entgegenhaltungen:
**EP-A2- 1 489 742           DE-A1-102011 085 547
DE-A1-102016 107 245**

EP 4 202 372 B1

**Beschreibung**

Die Erfindung betrifft ein Verfahren zum Filtern eines Sensorsignals sowie ferner eine Vorrichtung zum Ansteuern eines Aktuators mittels Filterung eines Sensorsignals.

Zur Erfassung von Zuständen bzw. Detektion von Ereignissen in der technisch-physikalischen Welt ist es üblich, mittels eines Sensors ein Sensorsignal zu erfassen und dieses zu filtern, beispielsweise um Rauschstörungen und/oder impulsartige Störungen in dem Sensorsignal zu reduzieren.

Als Filterungsmethoden sind zeitdiskrete Filter wohlbekannt. Einfache Filter sind hierbei beispielsweise ein sogenannter Medianfilter oder ein Mittelwertfilter bzw. arithmetischer Mittelwertfilter.

Bei derartigen zeitdiskreten Filtermethoden im Zeitbereich wird für einen bestimmten Zeitindex ein neuer Ausgangswert für ein Ausgangssignal dadurch ermittelt, dass mehrere Eingangswerte von mehreren diskreten Zeitpunkten miteinander arithmetisch verknüpft werden, um dann den einen Ausgangswert des Ausgangssignals zu dem einen zeitdiskreten Zeitpunkt zu ermitteln.

Ein derartig bestimmtes Ausgangssignal kann dann beispielsweise zur Detektion eines Ereignisses herangezogen werden. Beispielsweise kann bei Erfassung eines Sensorsignals mittels eines Drucksensors ein Übersteigen eines bestimmten Druckwertes detektiert werden. Vorzugsweise kann dann in einem solchen Fall bzw. bei Detektion eines solchen Ereignisses ein Aktuator angesteuert werden, um bestimmte Wirkungen in der physikalisch-technischen Welt herbeizuführen.

Als Sensoren sind unterschiedlichste Sensoren bekannt. Beispielsweise gibt es kapazitive Sensoren, Drucksensoren, Spannungssensoren, Feuchtesensoren sowie viele andere Formen von Sensoren. Gemein haben diese Sensoren, dass ihre bereitgestellten analogen elektrischen Sensorsignale Rauschstörungen und ggf. auch impulsartigen Störungen unterliegen, welche das eigentlich zu erwartende Sensorsignal leicht oder auch stark verfälschen.

Neben zeitdiskreten Filtern sind auch andere Filterungsmethoden, beispielsweise im Frequenzbereich, bekannt.

Unterschiedliche Filterungsmethoden wirken sich unterschiedlich auf das Ausgangssignal aus.

Methoden mit aufwendiger Filterung, beispielsweise anhand von Transformation des zeitdiskreten Eingangssignals in einen diskreten Frequenzraum, Filterung in dem diskreten Frequenzraum und Rücktransformation in ein zeitdiskretes Ausgangssignal, möglicherweise auch noch mit Überlappung von zeitdiskreten Ausgangssignalblöcken mittels Overlap-Add Verfahren, erzeugen mitunter eine gewisse Latenz.

Auch jedes zeitdiskrete Filter in einer zeitdiskreten Implementation, beispielsweise als FIR-Filter oder IIR-Filter, erzeugt eine gewisse Signallatenz. Solche Signallatenzen können dann dazu führen, dass auf Basis des Ausgangssignals eine Detektion eines bestimmten Ereignisses, welches in dem Eingangssignal durch einen bestimmten Signalverlauf wie beispielsweise einen Signalsprung indiziert ist, nur zeitverzögert mit der entsprechenden Latenz festgestellt werden kann.

Gleichzeitig ist es so, dass jeweilige, unterschiedliche Filterungsmethoden zu jeweiligen, unterschiedlichen Graden jeweilige, unterschiedliche Reduktionen einer Rauschstörung und/oder Impulsstörung bewirken.

Derartige Aspekte sind nicht immer gemeinsam so zu optimieren, dass alle solche Aspekte zu einem jeweiligen maximal optimalen Grad gemeinsam erreicht werden können. Manche Filterungsmethoden erreichen eine höhere Rauschreduktion, jedoch für den Preis einer höheren Signallatenz. Weitere Zusammenhänge sind hierbei möglich und bekannt.

Unterschiedliche Methoden der zeitdiskreten Signalfilterung sind bekannt aus "Digitale Signalverarbeitung - Filterung und Spektralanalyse mit MATLAB®-Übungen - K.-D. Kammeyer, K. Kroschel, Springer Vieweg, Wiesbaden, Deutschland, 21. April 2018" sowie " A. Mertins: Signaltheorie: Grundlagen der Signalbeschreibung, Filterbänke, Wavelets, Zeit-FrequenzAnalyse, Parameter- und Signalschätzung. Springer Vieweg, 4. Auflage, 2020."

Weiterhin ist aus EP 1 489 742 A2 ein Verfahren und eine Vorrichtung zur Filterung eines Signals bekannt.

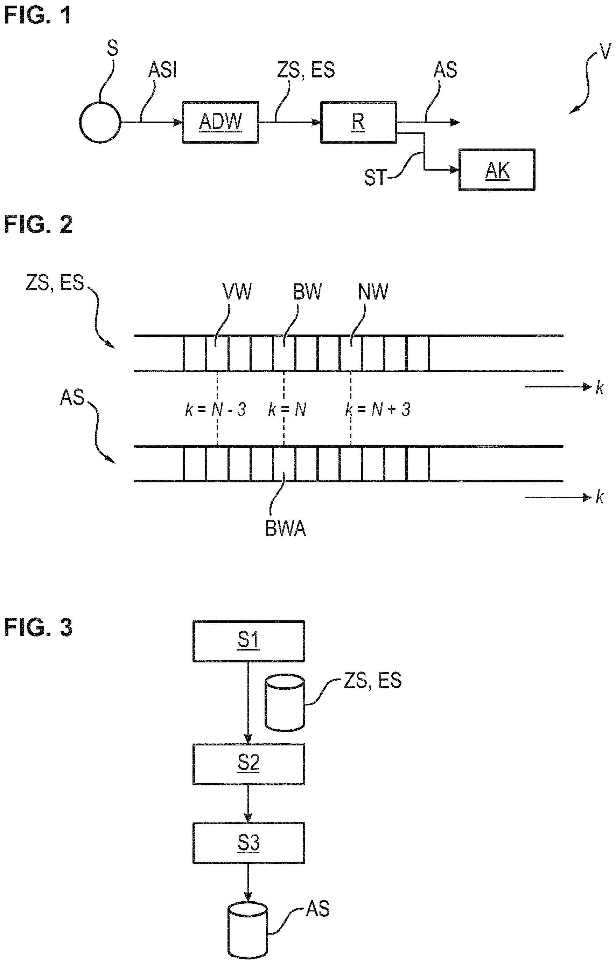

Die Figur 1 zeigt einen Sensor S, welcher ein analoges Sensorsignal AS bereitstellt. Dieses analoge Sensorsignal wird mittels einer Wandlereinheit ADW, insbesondere eines AD-Wandlers, in ein zeitdiskretes Sensorsignal ZS gewandelt. Dieses zeitdiskrete Sensorsignal ZS kann als ein zeitdiskretes Eingangssignal ES aufgefasst werden. Eine Recheneinheit R kann dann mittels zeitdiskreter Filterung im Zeitbereich ein zeitdiskretes Ausgangssignal AS bestimmen. Ferner kann die Recheneinheit R vorzugsweise auf Basis des Ausgangssignals AS ein bestimmtes Ereignis detektieren, um dann ein bestimmtes Steuersignal ST an einen Aktuator AK auszugeben.

Aufgabe der vorliegenden Erfindung ist es, ein Filterungsverfahren zur Filterung eines zeitdiskreten Eingangssignals und Bestimmung eines zeitdiskreten Ausgangssignals bereitzustellen, welches sowohl einer Störgröße wie beispielsweise additivem Rauschen entgegenwirkt und gleichzeitig das Eingangssignal möglichst wenig verfälscht.

Die erfindungsgemäße Aufgabe wird gelöst durch das erfindungsgemäße Verfahren zum Filtern eines Sensorsignals nach Anspruch 1.

Die erfindungsgemäße Aufgabe wird ferner gelöst durch eine erfindungsgemäße Vorrichtung zum Ansteuern eines Aktuators mittels Filterung eines Sensorsignals nach dem Anspruch 12.

Vorgeschlagen wird ein erfindungsgemäßes Verfahren wie in Anspruch 1 definiert.

Vorzugsweise erfolgt entweder ein Beibehalten des bestimmten Signalwertes des Eingangssignals in dem Ausgangssignal oder ein Ersetzen des bestimmten Signalwertes des Eingangssignals in dem Ausgangssignal durch einen neuen Wert in Abhängigkeit eines Vergleichs des bestimmten Signalwertes des Eingangssignals mit einem durch die zwei weiteren Signalwerte des Eingangssignals aufgespannten Werte-Intervalls.

Zur Darlegung eines oder mehrerer möglicher Vorteile des erfindungsgemäßen Verfahrens folgen nun genauere Ausführungen.

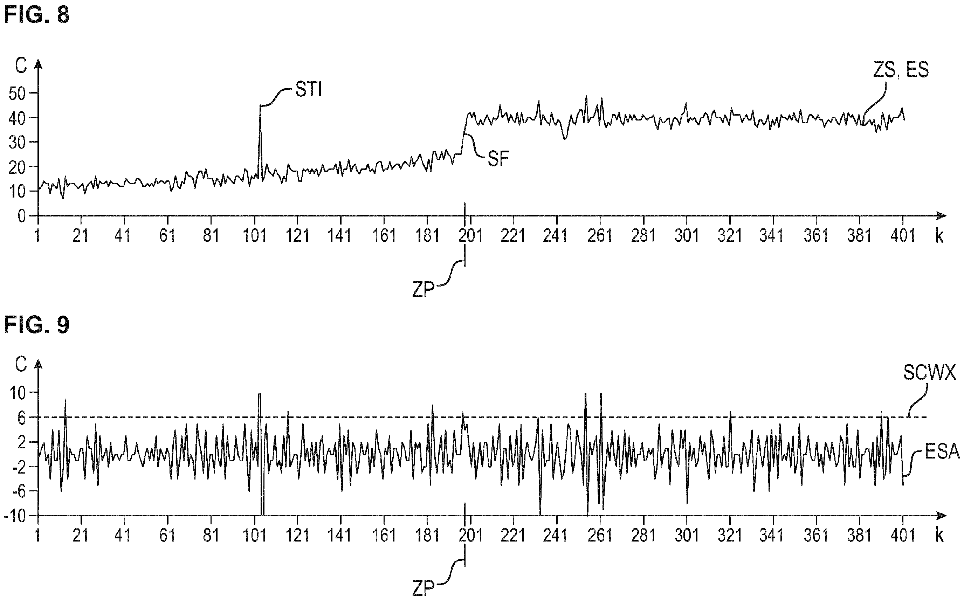

Die Figur 8 zeigt ein beispielhaftes Eingangssignal ES, welches durch additives Rauschen überlagert ist und eine Signalflanke SF zu einem bestimmten Zeitpunkt ZP aufweist. Eine solche Signalflanke SF indiziert ein bestimmtes Ereignis in der physikalisch-technischen Welt. Ferner weist das Sensorsignal ES einen Störimpuls STI auf. Sowohl das additive Rauschen als auch der Störimpuls STI sollen durch eine zeitdiskrete Filterung reduziert werden, um dann auf Basis des Ausgangssignals möglichst ohne größere Signallatenz eine Signalflanke SF bzw. ein durch die Signalflanke SF indiziertes Ereignis detektieren zu können.

Die Figur 9 zeigt die erste Ableitung des zeitdiskreten Signals ES als ein Signal ESA. Hierbei ist beispielsweise das Signal-Rausch-Verhältnis kleiner als 1.

Eine Detektion des Ereignisses bzw. der Signalflanke SF zu dem Zeitpunkt ZP auf Basis des Signals ESA unter Anwendung eines Schwellenwertes SCW kann nicht unbedingt zu einem sicheren Detektionsergebnis führen. Andere Signalwerte des Signals ESA zu anderen Zeitpunkten überschreiten ebenfalls den Schwellenwert SCWX.

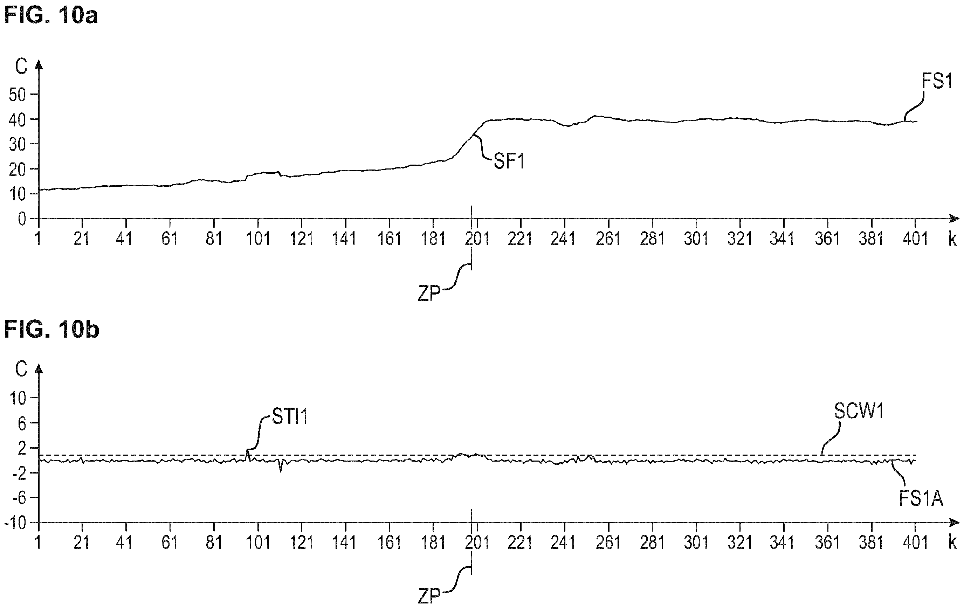

Die Figur 10A zeigt ein beispielhaftes Ausgangssignal FS1 in dem Fall, dass ein übliches durchgehendes arithmetisches Mittelwertfilter auf das Eingangssignal ES aus der Figur 8 angewendet wird.

Die verbleibende Flanke SF1 weist eine geringere Flankensteilheit als die ursprüngliche Flanke SF aus dem Signal ES auf. Rauschanteile sowie ein Impuls konnten jedoch reduziert werden. Eine erste Ableitung FS1A des Signals FS1 ist in der Figur 10B gezeigt. Hierbei ist immer noch eine Anwendung eines Schwellenwertes SCW1 zur Detektion des Ereignisses zu dem Zeitpunkt ZP problembehaftet, da auch andere Signalanteile wie der verbleibende Impuls STI1 in dem Signal FS1A den Schwellenwert SCW1 überschreiten.

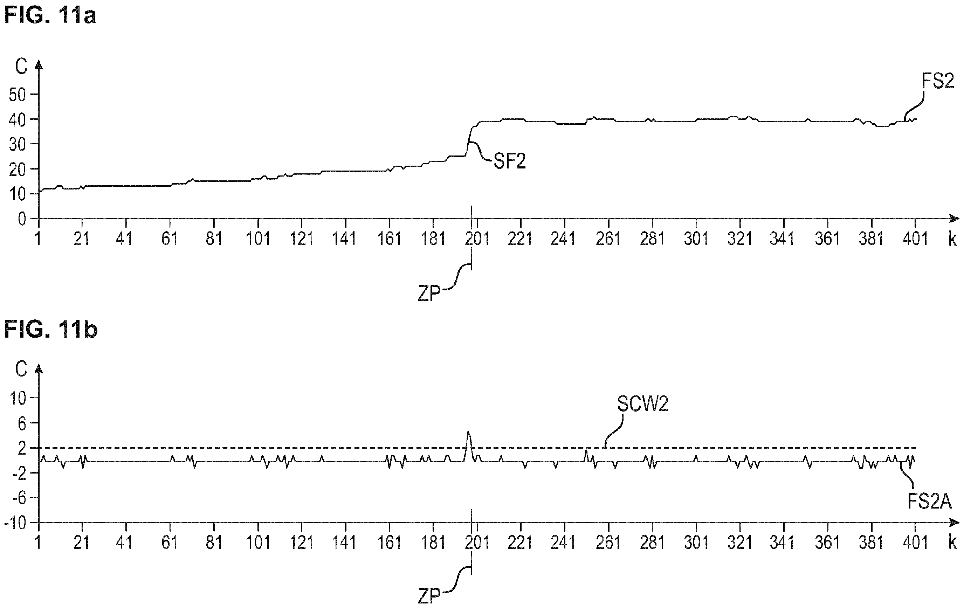

Die Figur 11A zeigt ein beispielhaftes Ausgangssignal FS2, bei welchem eine bekannte durchgehende Medianfilterung mittels eines zeitdiskreten Medianfilters auf das Eingangssignal angewendet wurde.

Die verbleibende Signalflanke SF2 weist eine höhere Flankensteilheit auf als im Falle des arithmetischen Mittelwertfilters, siehe Figur 10A. Rauschanteile können jedoch nur zu einem geringeren Anteil reduziert werden als bei einer arithmetischen Mittelwertfilterung. Eine in Figur 11B gezeigte erste Ableitung FS2A des Ausgangssignals FS2 erlaubt hier eine Anwendung eines Schwellenwertes SCW2, um ein Ereignis bzw. einen Signalanstieg zu dem Zeitpunkt ZP zu detektieren.

Das sich ergebende Signal-Rausch-Verhältnis ist hierbei von einem beispielhaften Wert von 2,5. Bei Anwendung des arithmetischen Mittelwertfilters wird nur ein Signal-Rausch-Verhältnis von weniger als 1 erreicht.

Die hier beispielhaft bekannten und beschriebenen zeitdiskreten Filterungsmethoden haben gemein, dass ein bestimmter Ausgangswert immer durch eine feste Anwendung einer arithmetischen Verknüpfung mehrerer Eingangswerte bestimmt wird.

Hiervon weicht das erfindungsgemäße Verfahren explizit ab, da erfindungsgemäß der bestimmte Signalwert des bestimmten Zeitindex mit einem Werte-Intervall verglichen wird, welches durch zwei weitere Signalwerte aufgespannt wird, und der bestimmte Signalwert in dem Ausgangssignal durch einen neuen Wert in Abhängigkeit des durch die weiteren Signalwerte aufgespannten Werte-Intervalls ersetzt wird. Vorzugsweise erfolgt entweder ein Beibehalten des bestimmten Signalwertes des Eingangssignals in dem Ausgangssignal oder ein Ersetzen des bestimmten Signalwertes des Eingangssignals in dem Ausgangssignal durch einen neuen Wert in Abhängigkeit eines Vergleichs des bestimmten Signalwertes des Eingangssignals mit einem durch die zwei weiteren Signalwerte des Eingangssignals aufgespannten Werte-Intervalls.

Eine Ersetzung des bestimmten Signalwertes erfolgt also durch einen neuen Wert, welcher durch arithmetische Verknüpfung mehrerer Eingangswerte ermittelt werden kann, nicht für jeden bestimmten Signalwert des Eingangssignals.

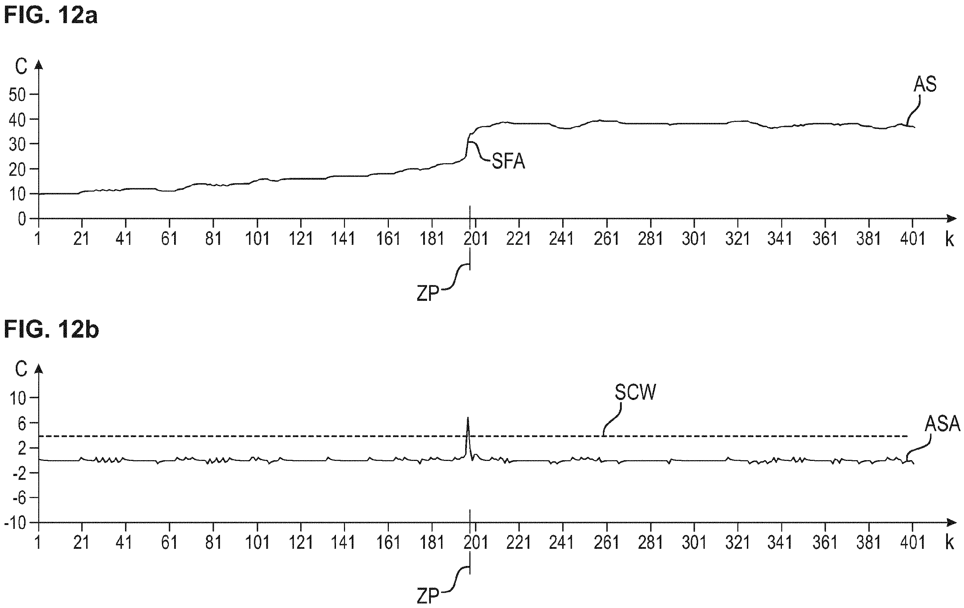

Das Ergebnis ist in der Figur 12A dargelegt, welches ein Ausgangssignal AS zeigt, das mittels der erfindungsgemäßen zeitdiskreten Filterung ermittelt wurde.

Die Flankensteilheit der verbleibenden Flanke SFA zum Zeitpunkt ZP ist deutlich höher als die der Flanken SF1 oder SF2 aus den Figur 10A bzw. 11A bei Anwendung eines Mittelwertfilters bzw. eines Medianfilters. Ferner wird in dem gefilterten Signal ein Signal-zu-Rausch-Verhältnis in diesem Signalbeispiel von 14 erreicht. Also wird durch das erfindungsgemäße Verfahren ein höheres Signal-zu-Rausch-Verhältnis gemeinsam mit höherer Flankensteilheit erreicht als bei den herkömmlichen Verfahren der zeitdiskreten Filterung. Wie aus der Figur 12A hervorgeht, ist ferner die Präsenz des Rauschanteils sowie auch des Störimpulses STI, siehe Figur 8, in dem Ausgangssignal AS stärker reduziert worden als bei den herkömmlichen Verfahren der zeitdiskreten Filterung. Dadurch, dass lediglich der bestimmte Wert mit dem Werteintervall verglichen werden muss, ist auch keine aufwendige Berechnung von Filterkoeffizienten wie beispielsweise einem Wiener-Filter oder einem Kalman-Filter notwendig.

Die erste Ableitung ASA aus Figur 12B des Ausgangssignals AS kann nun zur Detektion eines Ereignisses an dem bestimmten Zeitpunkt ZP mittels Schwellenwertanwendung eines Schwellenwertes SCW verwendet werden.

Mit anderen Worten: das erfindungsgemäße Verfahren, bei welchem nur in bestimmten Fällen der bestimmte Signalwert durch einen neuen Wert in Abhängigkeit eines durch die weiteren Signalwerte aufgespannten Werte-Intervalls ersetzt wird, ist also hinsichtlich einer Reduktion von Rausch- und/oder Störanteilen als auch einem Erhalt einer Flankensteilheit den bekannten Verfahren überlegen.

Es sei darauf hingewiesen, dass zur Detektion des Ereignisses die Analyse des Ausgangssignal AS mittels Ermittlung seiner ersten Ableitung ASA und einer Bestimmung eines Überschreitens eines vorgegebenen Schwellenwertes nur ein näher hier illustriertes Verfahren ist und nur ein Beispiel zur Detektion des Ereignisses mittels Detektieren einer signifikanten Signaländerung auf Basis des Ausgangssignals. Ein weiteres Beispiel wäre eine Kantendetektion bzw. eine Flankendetektion in dem Ausgangssignals unter Verwendung eines Sobel-Operators oder eines Laplace-Operators. Auch andere Detektionsverfahren zur Flankendetektion bzw. Kantendetektion können hierbei zum Zuge kommen.

Vorteilhafte Ausführungsformen der Erfindung sind Gegenstand der abhängigen Ansprüche und werden in der folgenden Beschreibung unter teilweise Bezugnahme auf die Figuren näher erläutert.

Vorzugsweise wird der neue Wert auf Basis der zwei weiteren Signalwerte bestimmt.

Vorzugsweise wird der neue Wert als der Mittelwert der zwei weiteren Signalwerte bestimmt.

Vorzugsweise wird der neue Wert als einer der zwei weiteren Signalwerte gewählt, zu welchem der bestimmte Wert eine kleinere Abweichung aufweist.

Vorzugsweise wird der neue Wert in Abhängigkeit eines der zwei weiteren Signalwerte, zu welchem der bestimmte Wert eine kleinere Abweichung aufweist, und einer Differenz des bestimmten Signalwertes und des einen der zweiten weiteren Signalwerte bestimmt. Besonders bevorzugt wird der neue Wert ferner auch noch in Abhängigkeit eines Korrektur-Wertes bestimmt.

Erfindungsgemäß erfolgt in dem Fall, dass der bestimmte Signalwert innerhalb des durch die zwei weiteren Signalwerte aufgespannten Werte-Intervalls liegt, ein unverändertes Beibehalten des bestimmten Signalwertes an dem bestimmten Zeitindex, sowie ferner in dem Fall, dass der bestimmte Signalwert nicht innerhalb des durch die zwei weiteren Signalwerte aufgespannten Werte-Intervalls liegt, ein Ersetzen des bestimmten Signalwertes an dem bestimmten Zeitindex durch den neuen Wert.

Vorzugsweise weisen die zwei weiteren Signalwerte jeweils einen gleichen zeitlichen Abstand zu dem bestimmten Signalwert auf.

Vorzugsweise weist das Verfahren die Schritte auf: Anwenden des zeitdiskreten Filters aus Anspruch 1 auf das Eingangssignal in einer ersten Filterstufe zum Erzeugen des Ausgangssignals, Bereitstellen des Ausgangssignals der ersten Filterstufe als ein zweites Eingangssignal einer zweiten Filterstufe, sowie Anwenden des zeitdiskreten Filters aus Anspruch 1 auf das zweite Eingangssignal in der zweiten Filterstufe zum Erzeugen eines zweiten Ausgangssignals.

Vorzugsweise ist das Verfahren so ausgestaltet, dass in der ersten Filterstufe in dem zeitdiskreten Filter die zwei weiteren Signalwerte einen ersten gleichen zeitlichen Abstand zu dem bestimmten Signalwert aufweisen, dass ferner in der zweiten Filterstufe in dem zeitdiskreten Filter die zwei weiteren Signalwerte einen zweiten gleichen zeitlichen Abstand zu dem bestimmten Signalwert aufweisen, und dass ferner der zweite zeitliche Abstand größer ist als der erste zeitliche Abstand.

Vorzugsweise weist das Verfahren die Schritte auf: Detektieren eines Ereignisses bei Detektieren einer signifikanten Signaländerung auf Basis des Ausgangssignals sowie Ansteuern eines Aktuators bei Detektion des Ereignisses.

Vorzugsweise erfolgt ein Erfassen des Sensorsignals mittels eines kapazitiven Sensors.

Vorgeschlagen wird ferner eine Vorrichtung wie in Anspruch 12 definiert.

Vorzugsweise ist das Ansteuersignal ein Signal zum Aktivieren des Aktuators oder ein Signal zum Anhalten des Aktuators.

Im Folgenden wird die Erfindung anhand spezieller Ausführungsformen ohne Beschränkung des allgemeinen Erfindungsgedankens anhand der Figuren näher erläutert. Dabei zeigen:

Figur 1 ein Blockschaltbild mit verschiedenen Komponenten und Signalen,

Figur 2 eine Darstellung eines zeitdiskreten Eingangssignals und eines zeitdiskreten Ausgangssignals,

Figur 3 Schritte einer bevorzugten Ausführungsform des erfindungsgemäßen Verfahrens,

Figur 4 ein Blockschaltbild zur Illustration eines zeitdiskreten Filters,

Figur 5 Schritte zur Bestimmung eines Wertes eines zeitdiskreten Ausgangssignals,

Figur 6A und Figur 6B bevorzugte Schritte bevorzugter Ausführungsformen des erfindungsgemäßen Verfahrens,

Figur 7 eine bevorzugte Ausführungsform einer erfindungsgemäßen Vorrichtung,

Figur 8 ein beispielhaftes Eingangssignal bzw. zeitdiskretes Sensorsignal,

Figur 9B eine erste Ableitung des Eingangssignals,

Figur 10A und B ein erstes gefiltertes Ausgangssignal sowie seine erste Ableitung,

Figur 11A und B ein weiteres gefiltertes Ausgangssignal sowie seine erste Ableitung,

Figur 12A ein Beispiel eines erfindungsgemäß gefilterten Ausgangssignals sowie seine erste Ableitung,

Figur 13A und B Ausführungsbeispiele zur Bestimmung eines neuen Wertes.

Die Figur 1 zeigt eine bevorzugte Ausführungsform einer erfindungsgemäßen Vorrichtung.

Ein Sensor S, welcher vorzugsweise ein kapazitiver Sensor ist, stellt ein analoges Sensorsignal ASI bereit. Das Signal ASI wird mittels einer Wandlereinheit ADW, vorzugsweise einem Analog-Digital-Wandler, in ein zeitdiskretes Sensorsignal ZS gewandelt, welches auch als ein zeitdiskretes Eingangssignal ES aufgefasst werden kann. Eine Recheneinheit R filtert dann das Eingangssignal ES zur Bestimmung eines zeitdiskreten Ausgangssignals AS. Vorzugsweise stellt die Recheneinheit R dieses Ausgangssignal AS bereit.

Vorzugsweise detektiert die Recheneinheit R ein Ereignis bei Detektieren einer signifikanten Signaländerung auf Basis des Ausgangssignals AS bzw. in dem Ausgangssignal AS. Vorzugsweise steuert die Recheneinheit R dann mittels eines auszugebenden Steuersignals ST einen Aktuator AK bei Detektion des Ereignisses an.

Wie zuvor dargelegt, können prinzipiell unterschiedliche Sensoren S eingesetzt werden. Die jeweiligen analogen Sensorsignale AS der jeweiligen Sensoren S können dann mittels des erfindungsgemäßen Verfahrens gefiltert werden. Hierbei ist die Erfindung nicht auf bestimmte Sensorarten beschränkt, da die zuvor genannten Problemstellungen, wie beispielsweise additives Rauschen oder Störimpulse und Filterung des Eingangssignals, zur möglichst guten Erhaltung der Flankensteilheit bei Sensorsignalen unterschiedlichster Sensorarten vorkommen.

Die Figur 2 zeigt ein Eingangssignal ES, welches zu einem ganz bestimmten zeitdiskreten Zeitpunkt k=N einen bestimmten Wert BW aufweist. Das Signal ES zeigt ferner einen Vorgängerwert VW auf, welcher beispielsweise drei diskrete Zeitpunkte zuvor zu dem Zeitpunkt k=N-3 vorlag. Ferner weist das Eingangssignal ES beispielsweise einen Nachfolgewert NW auf, welcher drei diskrete Zeitpunkte später zum Zeitpunkt k=N+3 in dem Eingangssignal ES auftritt.

Auf Basis der Werte VW, BW, NW wird ein Ausgabewert BWA des Ausgangssignals AS für den bestimmten Zeitpunkt k=N bestimmt. Der Ausgangswert BWA wird in der Weise bestimmt, dass entweder der bestimmte Signalwert BW des Eingangssignals ES beibehalten wird für den Zeitpunkt k=N oder aber dass der bestimmte Signalwert BW in Abhängigkeit der zwei weiteren Signalwerte VW, NW durch einen neuen Wert in Abhängigkeit eines durch die zwei weiteren Signalwerte VW, NW aufgespannten Werte-Intervalls ersetzt wird. Genauere Ausführungen hierzu folgen nun.

Die Figur 3 zeigt einen Schritt S1, in welchem das zeitdiskrete Sensorsignal bereitgestellt wird als das Signal ZS, welches das eine Eingangssignal ES repräsentiert.

In einem Schritt S2 erfolgt das Vergleichen eines bestimmten Signalwertes eines bestimmten Zeitindex des Eingangssignals ES mit zwei weiteren Signalwerten des Eingangssignals, wobei ein erster Signalwert der zwei weiteren Signalwerte zeitlich vor dem bestimmten Signalwert liegt, der Wert VW aus der Figur 2, und wobei ein zweiter Signalwert der weiteren Signalwerte zeitlich nach dem bestimmten Signalwert liegt, der Wert NW aus der Figur 2.

In einem Schritt S3 erfolgt dann das Ersetzen des bestimmten Signalwertes durch einen neuen Wert in Abhängigkeit eines durch die zwei weiteren Signalwerte aufgespannten Werte-Intervalls zur Bestimmung des Ausgangssignal AS. Abstrakt kann festgestellt werden, dass in dem Ausgangssignal AS der bestimmte Signalwert BW dann eben durch einen neuen Wert in Abhängigkeit der zwei weiteren Signalwerte NW, VW ersetzt wird.

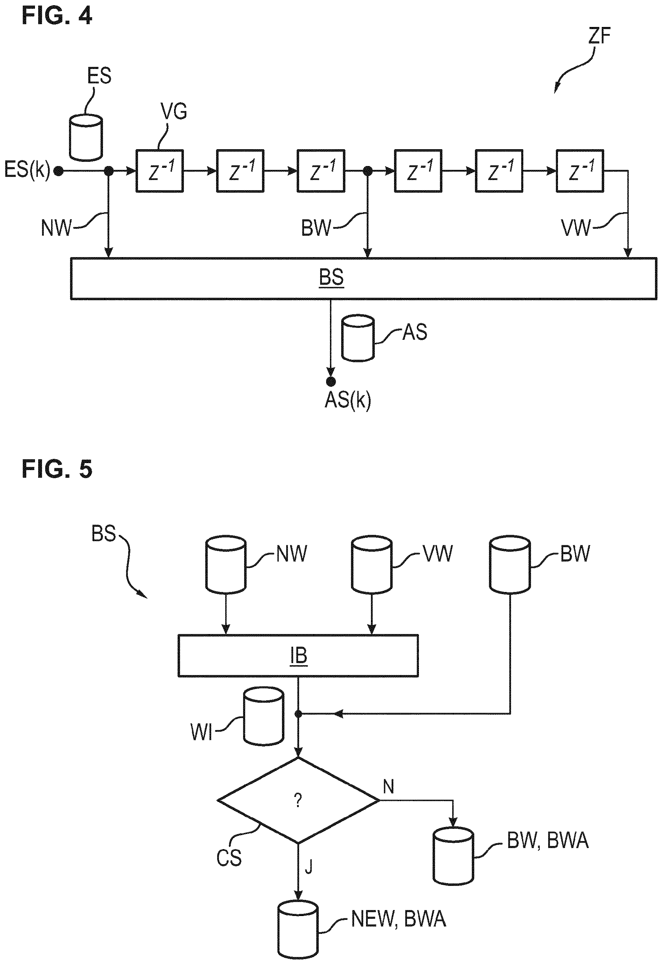

Die Figur 4 zeigt eine bevorzugte Ausführungsform eines zeitdiskreten Filters ZF in einer Darstellung als ein Blockschaltbild, bei welchem das Eingangssignal ES mit seinen zeitdiskreten Werten ES(k) einer Kette von Verzögerungsgliedern VG zugeführt wird.

Zu einem bestimmten, beispielhaften Zeitpunkt kann ohne Beschränkung der Allgemeinheit angenommen werden, dass beispielsweise zu diesem hier illustrierten Zeitpunkt am Eingang des Filters ZF der Nachfolgewert NW anliegt, nach drei Verzögerungsgliedern VG der bestimmte Signalwert BW und nach weiteren drei Verzögerungsgliedern der vorangegangene Wert VW.

In einem Bestimmungsschritt BS wird dann das Ausgangssignal AS bestimmt und mit seinen zeitdiskreten Werten AS(k) ausgegeben.

Die Figur 5 zeigt detaillierte Schritte einer bevorzugten Ausführungsform des erfindungsgemäßen Verfahrens.

Es wird eben insbesondere in dem Fall, dass eine vorgegebene Bedingung durch den bestimmten Wert BW in Bezug auf das Werte-Intervall der Werte VW, NW erfüllt wird, der bestimmte Signalwert BW durch einen neuen Wert ersetzt. In dem Fall, dass die vorgegebene Bedingung durch den bestimmten Wert in Bezug auf das Werte-Intervall nicht erfüllt wird, wird insbesondere der bestimmte Signalwert BW unverändert in dem Ausgangssignal beibehalten.

Die Werte NW und VW werden in einem Schritt IB herangezogen, um das Werte-Intervall WI mit seinen Grenzen zu bestimmen.

Es erfolgt dann in einem Vergleichsschritt CS ein Vergleich des bestimmten Wertes BW mit dem Werte-Intervall WI. Hierbei wird also eine vorgegebene Bedingung in Bezug auf den bestimmten Wert BW und das Werte-Intervall WI bzw. in Bezug auf den bestimmten Wert BW und die Werte NW, VW überprüft.

Wird die vorgegebene Bedingung erfüllt, so wird der bestimmte Signalwert BW durch einen neuen Wert NEW ersetzt, welches dann der Ausgangswert BWA ist, welcher in dem Ausgangssignal AS ausgegeben wird, wie in der Figur 2 dargestellt.

Wird die vorgegebene Bedingung durch den bestimmten Wert BW in Bezug auf die Werte NW, VW bzw. deren Werte-Intervall nicht erfüllt, so wird der bestimmte Signalwert BW unverändert beibehalten und als der Ausgabewert BWA in dem Ausgangssignal AS ausgegeben, wie in der Figur 2 ersichtlich wird.

Insbesondere wird in dem Fall, dass der bestimmte Signalwert BW innerhalb des durch die weiteren Signalwerte NW, VW aufgespannten Werte-Intervalls liegt, der bestimmte Signalwert BW an dem bestimmten Zeitindex unverändert beibehalten. Ferner wird eben insbesondere in dem Fall, dass der bestimmte Signalwert BW nicht innerhalb, sondern eben insbesondere außerhalb, des durch die weiteren Signalwerte NW, VW aufgespannten Werte-Intervalls liegt, der bestimmte Signalwert an dem bestimmten Zeitindex durch den neuen Wert NEW ersetzt.

Beispielsweise lässt sich eine Bestimmung des neuen Wertes und die Bedingungsüberprüfung dadurch beschreiben, dass ohne Beschränkung der Allgemeinheit in dem Fall, dass der Nachfolgewert NW kleiner als der Vorgängerwert VW ist,

$$NW < VW$$

dann die Bedingung formulieren zu

$$BW \in [NW, VW]$$

Ist diese Bedingung, dass der bestimmte Wert BW innerhalb des aufgespannten Werte-Intervalls $[NW, VW]$ liegt, erfüllt, dann ist der neue Wert NEW in Abhängigkeit der weiteren Signalwerte NW, VW zu bestimmen. Ist diese Bedingung nicht erfüllt, so wird der bestimmte Wert BW als der Ausgangswert BWA beibehalten.

Beispielsweise lässt sich eine Bestimmung des neuen Wertes und die Bedingungsüberprüfung dadurch beschreiben, dass ohne Beschränkung der Allgemeinheit in dem Fall, dass der Nachfolgewert NW größer als der Vorgängerwert VW ist,

$$NW > VW$$

dann die Bedingung formulieren zu

$$BW \in [VW, NW]$$

Ist diese Bedingung, dass der bestimmte Wert BW innerhalb des aufgespannten Werte-Intervalls $[VW, NW]$ liegt, erfüllt, dann ist der neue Wert NEW in Abhängigkeit der weiteren Signalwerte NW, VW zu bestimmen. Ist diese Bedingung nicht erfüllt, so wird der bestimmte Wert BW als der Ausgangswert BWA beibehalten.

Mit anderen Worten: Vorzugsweise wird der bestimmte Signalwert BW in dem Ausgangssignal dann durch einen neuen Wert in Abhängigkeit eines durch die zwei weiteren Signalwerte NW, VW aufgespannten Werte-Intervalls

$[VW, NW]$ ersetzt, wenn der bestimmte Signalwert BW außerhalb des durch die zwei weiteren Signalwerte NW, VW aufgespannten Werte-Intervalls $[VW, NW]$ liegt.

Hierbei ist vorzugsweise der neue Wert NEW als der arithmetische Mittelwert der weiteren Signalwerte NW, VW zu bestimmen als

$$NEW = \frac{1}{2}(NW + VW)$$

Insbesondere kann bevorzugt eine Gewichtung der weiteren Signalwerte NW, VW vorgenommen werden gemäß

$$NEW = (0{,}6 \cdot NW + 0{,}4 \cdot VW)$$

Insbesondere kann der neue Wert als einer der zwei weiteren Signalwerte gewählt werden, wobei der bestimmte Wert zu dem gewählten der zwei weiteren Signalwerte eine kleinere Abweichung aufweist als eine Abweichung zu dem anderen der zwei weiteren Signalwerte, welcher nicht gewählt wird.

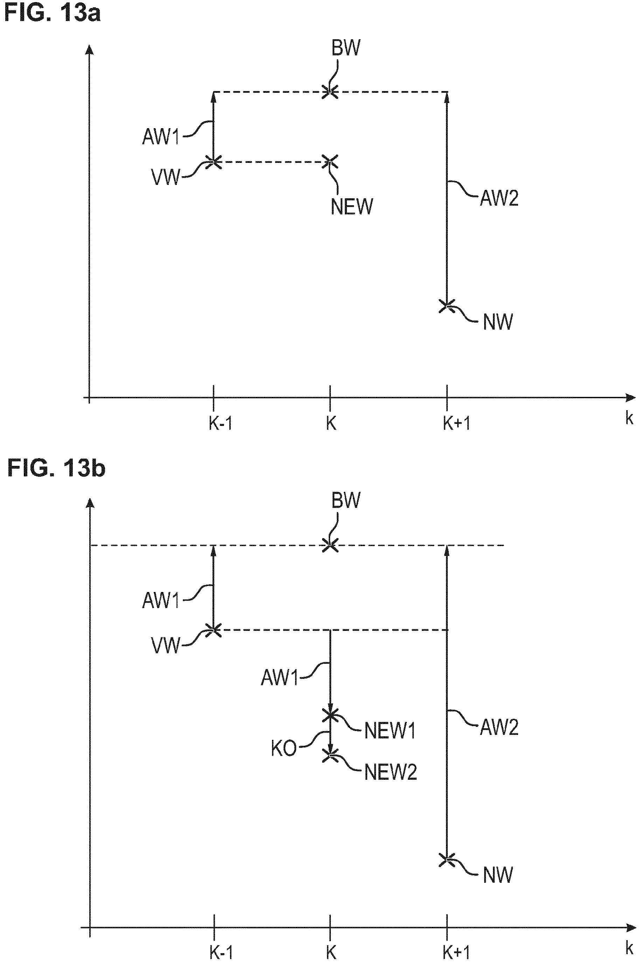

Hierzu ist ein Ausführungsbeispiel in der Figur 13A illustriert. Der bestimmte Wert BW weist eine Abweichung AW1 zu einem Wert VW der zwei weiteren Signalwerte VW, NW auf. Zu dem anderen Signal wird NW der zwei weiteren Signalwerte VW, NW weist der bestimmte Wert BW eine Abweichung AW2 auf. Die Abweichung AW1 ist kleiner als die Abweichung AW2. Daher wird der neue Wert NEW als ein Wert gewählt, welcher gleich dem Wert VW ist.

Bevorzugt wird der neue Wert in Abhängigkeit eines der zwei weiteren Signalwerte, zu welchem der bestimmte Wert eine kleinere Abweichung aufweist, und einer Differenz des bestimmten Signalwertes und des einen der zwei weiteren Signalwerte bestimmt. Hierzu zeigt die Figur 13B ein Ausführungsbeispiel. Der bestimmte Wert BW weist eine Abweichung AW1 zu dem Wert VW und eine Abweichung AW2 zu dem Wert NW auf. Es wird dann also aus den zwei weiteren Signalwerten VW, NW der eine Wert VW der zwei weiteren Signalwerte VW, NW ausgewählt, da dieser eine geringere Abweichung AW1 zu dem bestimmten Wert BW aufweist als der andere Wert NW mit seiner Abweichung AW2. Der neue Wert NEW1 wird dann bestimmt, indem von dem einen Wert VW der zwei weiteren Signalwerte VW, NW die Differenz AW1 zwischen dem einen Wert VW der zwei weiteren Signalwerte VW, NW und dem bestimmten Wert von diesem Wert VW abgezogen wird.

Besonders bevorzugt wird ein neuer Wert NEW2 in einer Abhängigkeit ferner eines Korrekturwertes KO bestimmt. Hierbei erfolgt eine zusätzliche Subtraktion des Korrekturwertes KO von dem zuvor bestimmten Wert NEW1.

Die weiteren Signalwerte NW, VW weisen insbesondere einen gleichen zeitlichen Abstand zu dem bestimmten Signalwert auf. Dieses war ein Abstand von drei Zeitindizes, wie in der Figur 2 dargelegt.

Vorzugsweise kann ein zeitlicher Abstand eines Nachfolgewertes NW größer sein als der eines Vorgängerwertes VW.

Die Leistungsfähigkeit des erfindungsgemäßen Verfahrens wurde bereits zuvor unter Bezug auf die Figur 8-12 dargelegt.

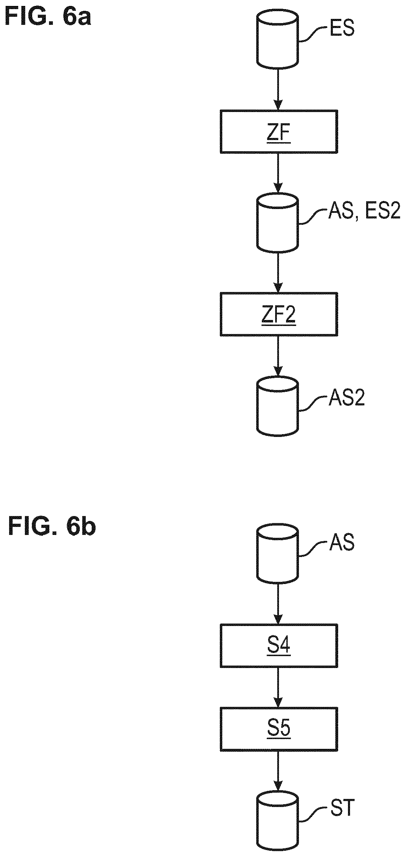

Die Figur 6A zeigt bevorzugte Schritte einer bevorzugten Ausführungsform des erfindungsgemäßen Verfahrens.

Hierbei erfolgt zunächst ein Anwenden eines zeitdiskreten Filters ZF auf das Eingangssignal ES einer ersten Filterstufe zum Erzeugen des Ausgangssignals AS. Das Ausgangssignal AS kann dann als ein zweites Eingangssignal ES einer zweiten Filterstufe bereitgestellt werden, in welcher ein zeitdiskretes Filter ZF2 auf das zweite Eingangssignal ES2 angewendet wird. Vorzugweise kann das zweite zeitdiskrete Filter ZF2 gleich dem ersten zeitdiskreten Filter ZF sein. Alternativ können beispielsweise die zeitlichen Abstände zwischen dem bestimmten Wert BW und den weiteren Signalwerten VW, NW in der zweiten Filterstufe des zweiten zeitdiskreten Filters ZF2 anders gewählt werden als in der ersten Filterstufe mit dem zeitdiskreten Filter ZF.

Die zweite Filterstufe wendet dann das zeitdiskrete Filter ZF2 auf das zweite Eingangssignal in der zweiten Filterstufe zum Erzeugen eines zweiten Ausgangssignals AS2 an.

Derartige Anwendungen kaskadierter zeitdiskreter Filter ZF, ZF2 in Serie können gegebenenfalls noch bessere Filterungsergebnisse erzielen.

Insbesondere weisen in der ersten Filterstufe die zwei weiteren Signalwerte einen ersten gleichen zeitlichen Abstand zu dem bestimmten Signalwert auf und in der zweiten Stufe die zwei weiteren Signalwerte einen zweiten gleichen Abstand zu dem bestimmten Signalwert, wobei der zweite zeitliche Abstand größer ist als der erste zeitliche Abstand.

Die Figur 6B zeigt weitere bevorzugte Schritte. Auf Basis des Ausgangssignals AS erfolgt in einem Schritt S4 ein Detektieren eines Ereignisses bei Detektieren einer signifikanten Signaländerung auf Basis des Ausgangssignals. In einem Schritt S5 erfolgt dann ein Ansteuern eines Aktuators bei Detektion des Ereignisses, beispielsweise durch Ausgabe des Steuersignals ST.

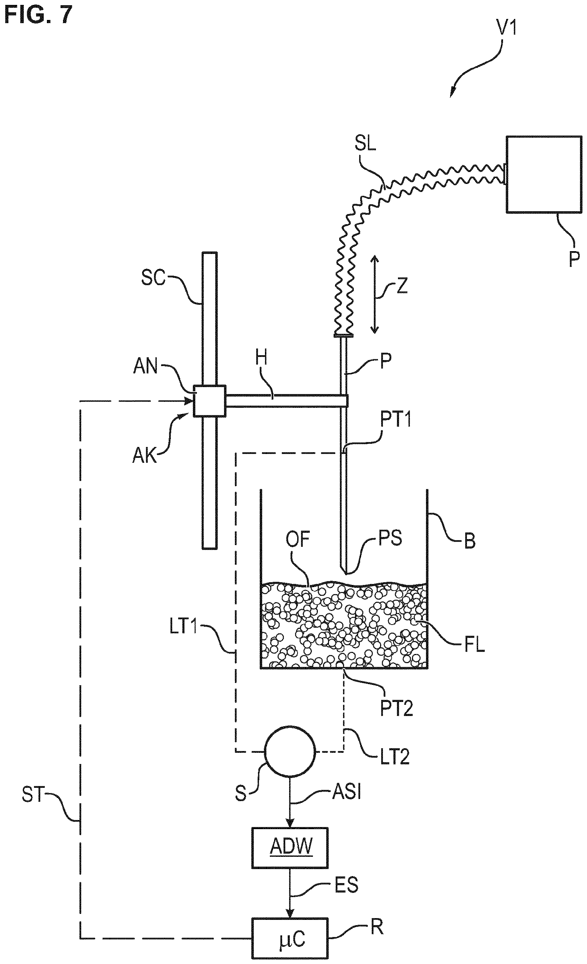

Figur 7 zeigt eine bevorzugte Ausführungsform V1 einer erfindungsgemäßen Vorrichtung.

Hierbei wird ein Anwendungsfall dargelegt, bei welchem ein Aktuator AK durch eine Recheneinheit R in Abhängigkeit des Sensorsignals AS des Sensors S kontrolliert bzw. gesteuert wird. Weitere Anwendungsfälle sind beispielsweise unter Verwendung von Drucksensoren, Feuchtigkeitssensoren und Temperatursensoren möglich.

In einem Behälter B befindet sich eine Flüssigkeit FL, welche mittels einer Pipettiernadel P zu einem gewissen Volumen aspiriert werden soll. Die Pipettiernadel ist beispielsweise durch einen Schlauch SL an eine Pumpe P angeschlossen. Die Pipettiernadel P ist über eine Halterung H beispielsweise mit einem Aktuator AK bzw. dessen Antriebseinheit AN gekoppelt.

Beispielsweise handelt es sich bei dem Aktuator AK um einen Linearmotor, bei welchem eine Antriebseinheit AN entlang einer Schiene SC läuft und gesteuert werden kann.

In diesem Anwendungsfall soll mittels des Aktuator AK die Pipettiernadel P in Z-Richtung so weit nach unten hin bewegt werden, bis die Spitze PS der Pipettiernadel P mit der Oberfläche OF der Flüssigkeit FL in Berührung kommt. Beispielsweise wird dies durch eine kapazitive Messung mittels eines kapazitiven Sensors S überwacht. Hierbei kann ein kapazitiver Sensor S über eine zweite Leitung LT2 mit einem Potenzialpunkt PT2 des Behälters B verbunden sein und über eine erste Leitung LT1 mit einem weiteren Potenzialpunkt PT1 der Pipettiernadel P.

Der Sensor S stellt das Sensorsignal ASI als ein analoges Signal bereit, welches mittels der Wandlereinheit ADW in ein zeitdiskretes Eingangssignal ES umgewandelt wird. Dieses Signal ES wird durch die Recheneinheit R gefiltert. Die Recheneinheit R steuert den Aktuator AK an.

Das Steuersignal ST als ein Ansteuersignal ist beispielsweise ein bestimmtes Ansteuersignal für den Aktuator bei Detektion des Ereignisses, dass die Spitze PS der Pipettiernadel P die Oberfläche OF der Flüssigkeit FL berührt. In einem solchen Fall kann dann beispielsweise das Ansteuersignal ein Stoppsignal sein, um den Aktuator anzuhalten, so dass die Spitze PS der Pipettiernadel P nicht weiter eintaucht.

Für einen Aspirationsvorgang kann dann beispielsweise nach Anhalten des Aktuators AK der Aktuator so angesteuert werden, dass die Pipettiernadel mit ihrer Spitze PS um eine weitere vordefinierte Wegstrecke in Z-Richtung nach unten hin bewegt wird, um dann ein bestimmtes Flüssigkeitsvolumen aspirieren zu können.

Das Verfahren des Aktuators AK entlang der vorbestimmten Wegstrecke kann beispielsweise mittels Überwachung von Encodersignalen an dem Aktuator AK bzw. dessen Motor überwacht werden, wobei insbesondere eine Startposition und eine Bewegungsgeschwindigkeit des Aktuators AK bekannt sein können. Ferner kann ein Anfahrverhalten des Aktuators AK in Z-Richtung bei nicht-linearer Bewegung bzw. nicht-konstanter Geschwindigkeit in der Bewegung bekannt sein und berücksichtigt werden.

Insbesondere kann vorzugsweise optional auf Basis eines Encodersignals an dem Aktuator AK eine Füllstandberechnung bzw. Berechnung des Restvolumens der Flüssigkeit FL in dem Behälter B ermittelt werden.

Viele Faktoren können Einfluss auf das Signal haben, wie beispielsweise Geometrie und Material, Flüssigkeiten und Füllstände sowie parasitäre Störungen.

Problematisch ist eine Detektion des Ereignisses der Berührung der Pipettenspitze PS mit der Oberfläche OF der Flüssigkeit FL insbesondere für kleine Füllstände.

Ein Detektieren des Ereignisses muss möglichst robust und allgemeingültig erfolgen. Eine Entscheidung muss beispielsweise in diesem Anwendungsfall innerhalb von sieben Messwerten bzw. zeitdiskreten Zeitpunkten mit Index K erfolgen, so dass eine höhere Signallatenz der Signalfilterung ungünstig wäre.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar.

Je nach bestimmten Implementierungsanforderungen können Ausführungsbeispiele der Erfindung in Hardware oder in Software implementiert sein. Die Implementierung kann unter Verwendung eines digitalen Speichermediums, beispielsweise einer Floppy-Disk, einer DVD, einer Blu-Ray Disc, einer CD, eines ROM, eines PROM, eines EPROM, eines EEPROM oder eines FLASH-Speichers, einer Festplatte oder eines anderen magnetischen oder optischen Speichers durchgeführt werden, auf dem elektronisch lesbare Steuersignale gespeichert sind, die mit einer programmierbaren Hardwarekomponente derart zusammenwirken können oder zusammenwirken, dass das jeweilige Verfahren durchgeführt wird.

Eine programmierbare Hardwarekomponente wie die hier genannte Recheneinheit kann durch einen Prozessor, einen Computerprozessor (CPU = Central Processing Unit), einen Grafikprozessor (GPU = Graphics Processing Unit), einen Computer, ein Computersystem, einen anwendungsspezifischen integrierten Schaltkreis (ASIC = Application-Specific Integrated Circuit), einen integrierten Schaltkreis (IC = Integrated Circuit), ein Ein-Chip-System (SOC = System on Chip), ein programmierbares Logikelement oder ein feldprogrammierbares Gatterarray mit einem Mikro-prozessor (FPGA = Field Programmable Gate Array) gebildet sein.

Das digitale Speichermedium kann daher maschinen- oder computerlesbar sein. Manche Ausführungsbeispiele umfassen also einen Datenträger, der elektronisch lesbare Steuersignale aufweist, die in der Lage sind, mit einem programmierbaren Computersystem oder einer programmierbare Hardwarekomponente derart zusammenzuwirken, dass eines der hierin beschriebenen Verfahren durchgeführt wird. Ein Ausführungsbeispiel ist somit ein Datenträger (oder ein digitales Speichermedium oder ein computerlesbares Medium), auf dem das Programm zum Durchführen eines der hierin beschriebenen Verfahren aufgezeichnet ist.

Allgemein können Ausführungsbeispiele der vorliegenden Erfindung als Programm, Firmware, Computerprogramm oder Computerprogrammprodukt mit einem Programmcode oder als Daten implementiert sein, wobei der Programmcode oder die Daten dahin gehend wirksam ist bzw. sind, eines der Verfahren durchzuführen, wenn das Programm auf einem Prozessor oder einer programmierbaren Hardwarekomponente abläuft. Der Programmcode oder die Daten kann bzw. können beispielsweise auch auf einem maschinenlesbaren Träger oder Datenträger gespeichert sein. Der Programmcode oder die Daten können unter anderem als Quellcode, Maschinencode oder Bytecode sowie als anderer Zwischencode vorliegen.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

**Patentansprüche**

1. Verfahren zum Filtern eines Sensorsignals, aufweisend

   - Bereitstellen eines zeitdiskreten Sensorsignals (ZS) als ein Eingangssignal (ES),
   - Erzeugen eines Ausgangssignals (AS) mittels fortlaufendes Filtern des Eingangssignals (ES) mittels eines zeitdiskreten Filters (ZF) in einem Zeitbereich, welches für einen jeweiligen Wert des Eingangssignals (ES) die folgenden Filterschritte durchführt :

      o Vergleichen eines bestimmten Signalwertes (BW) eines bestimmten Zeitindex des Eingangssignals (ES) mit zwei weiteren Signalwerten (VW, NW) des Eingangssignals (ES), wobei ein erster Signalwert (VW) der zwei weiteren Signalwerte (WV, NW) zeitlich vor dem bestimmten Signalwert (BW) liegt und wobei ein zweiter Signalwert (NW) der weiteren Signalwerte (VW, NW) zeitlich nach dem bestimmten Signalwert (BW) liegt,

      - Ersetzen des bestimmten Signalwertes (BW) an dem bestimmten Zeitindex in dem Ausgangssignal durch einen neuen Wert in dem Fall, dass der bestimmte Signalwert (BW) außerhalb des durch die zwei weiteren Signalwerte (VW, NW) aufgespannten Werte-Intervalls liegt,

**gekennzeichnet durch**

    o unverändertes Beibehalten des bestimmten Signalwertes (BW) an dem bestimmten Zeitindex in dem Fall, dass der bestimmte Signalwert (BW) innerhalb eines durch die zwei weiteren Signalwerte (VW, NW) aufgespannten Werte-Intervalls liegt.

2. Verfahren nach Anspruch 1,
**dadurch gekennzeichnet, dass** der neue Wert (NW) auf Basis der zwei weiteren Signalwerte (VW, NW) bestimmt wird.

3. Verfahren nach Anspruch 2,
**dadurch gekennzeichnet, dass** der neue Wert (NEW) als der Mittelwert der zwei weiteren Signalwerte (WV, NW) bestimmt wird.

4. Verfahren nach Anspruch 2,
**dadurch gekennzeichnet, dass** der neue Wert (NEW) als einer der zwei weiteren Signalwerte (VW, NW) gewählt wird, zu welchem der bestimmte Wert (BW) eine kleinere Abweichung aufweist.

5. Verfahren nach Anspruch 2,

    **dadurch gekennzeichnet, dass** der neue Wert (NW1) in Abhängigkeit

        - eines der zwei weiteren Signalwerte (VW), zu welchem der bestimmte Wert (BW) eine kleinere Abweichung (AW1) aufweist,
        - und einer Differenz (AW1) des bestimmten Signalwertes (BW) und des einen der zweiten weiteren Signalwerte (VW)

    bestimmt wird.

6. Verfahren nach Anspruch 2,

    **dadurch gekennzeichnet, dass** der neue Wert (NEW2) in Abhängigkeit

        - eines der zwei weiteren Signalwerte (VW), zu welchem der bestimmte Wert (BW) eine kleinere Abweichung (AW1) aufweist,
        - sowie ferner einer Differenz (AW1) des bestimmten Signalwertes (BW) und des einen der zweiten weiteren Signalwerte (VW)
        - und ferner eines Korrektur-Wertes (KO)

    bestimmt wird.

7. Verfahren nach Anspruch 1,
wobei die zwei weiteren Signalwerte (VW, NW) jeweils einen gleichen zeitlichen Abstand zu dem bestimmten Signalwert (BW) aufweisen.

8. Verfahren nach Anspruch 1, aufweisend

    - Anwenden des zeitdiskreten Filters (ZF) aus Anspruch 1 auf das Eingangssignal (ES) in einer ersten Filterstufe zum Erzeugen des Ausgangssignals (AS),
    - Bereitstellen des Ausgangssignals (AS) der ersten Filterstufe (ZF) als ein zweites Eingangssignal (ES2) einer zweiten Filterstufe (ZF2),
    - Anwenden des zeitdiskreten Filters aus Anspruch 1 auf das zweite Eingangssignal (ES2) in der zweiten Filterstufe (ZF2) zum Erzeugen eines zweiten Ausgangssignals (AS2).

9. Verfahren nach Anspruch 8,

    wobei in der ersten Filterstufe (ZF) in dem zeitdiskreten Filter die zwei weiteren Signalwerte (VW, NW) einen ersten gleichen zeitlichen Abstand zu dem bestimmten Signalwert (BW) aufweisen,
    wobei in der zweiten Filterstufe (ZF2) in dem zeitdiskreten Filter die zwei weiteren Signalwerte (VW, NW) einen zweiten gleichen zeitlichen Abstand zu dem bestimmten Signalwert (BW) aufweisen,
    und wobei der zweite zeitliche Abstand größer ist als der erste zeitliche Abstand.

10. Verfahren nach einem der vorhergehenden Ansprüche, aufweisend

    - Detektieren eines Ereignisses bei Detektieren einer signifikanten Signaländerung auf Basis des Ausgangssignals (AS) sowie
    - Ansteuern eines Aktuators (AK) bei Detektion des Ereignisses.

11. Verfahren nach einem der vorhergehenden Ansprüche, aufweisend

    - Erfassen des Sensorsignals (ZS) mittels eines kapazitiven Sensors.

12. Vorrichtung zum Ansteuern eines Aktuators mittels Filterung eines Sensorsignals,

    aufweisend

        - einen Sensor (S) zum Erfassen eines analogen Sensorsignals (ASI), insbesondere einen kapazitiven Sensor,
        - einen Wandler zum Bereitstellen des analogen Sensorsignals (ASI) in Form eines zeitdiskreten Sensorsignals (ZS) als ein Eingangssignal (ES),
- eine Recheneinheit (R) zum Entgegennehmen des Eingangssignals (ES) sowie
- einen Aktuator (AK)

wobei die Recheneinheit (R) ausgebildet ist, die folgenden Schritte auszuführen:

- Erzeugen eines Ausgangssignals (AS) durch fortlaufendes Filtern des Eingangssignals (ES) mittels eines zeitdiskreten Filters (ZF) in einem Zeitbereich, wobei das Filter (ZF) für einen jeweiligen Wert des Eingangssignals (ES) die folgenden Filterschritte durchführt :

○ Vergleichen eines bestimmten Signalwertes (BW) eines bestimmten Zeitindex des Eingangssignals (ES) mit zwei weiteren Signalwerten (VW, NW) des Eingangssignals (ES), wobei ein erster Signalwert (VW) der zwei weiteren Signalwerte zeitlich vor dem bestimmten Signalwert (BW) liegt und wobei ein zweiter Signalwert (NW) der weiteren Signalwerte zeitlich nach dem bestimmten Signalwert (BW) liegt,
○ Ersetzen des bestimmten Signalwertes (BW) an dem bestimmten Zeitindex in dem Ausgangssignal (AS) durch einen neuen Wert in dem Fall, dass der bestimmte Signalwert (BW) außerhalb des durch die zwei weiteren Signalwerte (VW, NW) aufgespannten Werte-Intervalls liegt,

wobei die Recheneinheit (R) ferner ausgebildet ist, die folgenden Schritte auszuführen:

- Detektieren eines Ereignisses mittels Detektieren einer signifikanten Signaländerung auf Basis des Ausgangssignals (AS) sowie
- Ausgeben eines Ansteuersignals an den Aktuator (AK) bei Detektion des Ereignisses, **dadurch gekennzeichnet, dass**
- unverändertes Beibehalten des bestimmten Signalwertes (BW) an dem bestimmten Zeitindex in dem Fall, dass der bestimmte Signalwert (BW) innerhalb eines durch die zwei weiteren Signalwerte (VW, NW) aufgespannten Werte-Intervalls liegt.

13. Vorrichtung nach Anspruch 12,

wobei das Ansteuersignal ein Signal zum Aktivieren des Aktuators (AK) ist
oder wobei das Ansteuersignal ein Signal zum Anhalten des Aktuators (AK) ist.

**Claims**

1. Method for filtering a sensor signal, comprising

- providing a time-discrete sensor signal (ZS) as an input signal (ES),
- generating an output signal (AS) via continuous filtering of the input signal (ES) using a time-discrete filter (ZF) in the time domain, which performs the following filter steps for each value of the input signal (ES):

○ comparing a specified signal value (BW) of a specified time index of the input signal (ES) with two further signal values (VW, NW) of the input signal (ES), wherein a first signal value (VW) of the two further signal values (WV, NW) is temporally prior to the specified signal value (BW) and wherein a second signal value (NW) of the further signal values (VW, NW) is temporally after the specified signal value (BW),
○ replacing the specified signal value (BW) at the specific time index in the output signal by a new value in the event that the specific signal value (BW) lies outside the value interval spanned by the two further signal values (VW, NW),
**characterized by**
○ retaining the specific signal value (BW) unchanged at the specific time index in the event that the specific signal value (BW) lies within a value interval spanned by the two further signal values (VW, NW).

2. Method according to Claim 1,
**characterized in that** the new value (NW) is determined on the basis of the two further signal values (VW, NW).

3. Method according to Claim 2,
**characterized in that** the new value (NW) is determined as the mean value of the two further signal values (WV, NW).

4. Method according to Claim 2,
**characterized in that** the new value (NEW) is selected as one of the two further signal values (VW, NW) from which the specified value (BW) has a smaller deviation.

5. Method according to Claim 2,
**characterized in that** the new value (NW1) is determined in dependence on

- one of the two further signal values (VW) from which the specified value (BW) has a smaller deviation (AW1),
- and a difference (AW1) between the specified signal value (BW) and the one of the two further signal values (VW).

6. Method according to Claim 2,
**characterized in that** the new value (NEW2) is determined in dependence on

- one of the two further signal values (VW) from which the specified value (BW) has a smaller deviation (AW1),
- and also a difference (AW1) between the specified signal value (BW) and the one of the two further signal values (VW)
- and also a correction value (KO).

7. Method according to Claim 1,
wherein the two further signal values (VW, NW) each have an equal temporal distance to the specified signal value (BW).

8. Method according to Claim 1, comprising

- applying the time-discrete filter (ZF) of Claim 1 to the input signal (ES) in a first filter stage for generating the output signal (AS),
- providing the output signal (AS) of the first filter stage (ZF) as a second input signal (ES2) of a second filter stage (ZF2),
- applying the time-discrete filter of Claim 1 to the second input signal (ES2) in the second filter stage (ZF2) for generating a second output signal (AS2).

9. Method according to Claim 8,

wherein in the first filter stage (ZF) in the time-discrete filter the two further signal values (VW, NW) each have a first equal temporal distance to the specified signal value (BW),
wherein in the second filter stage (ZF) in the time-discrete filter the two further signal values (VW, NW) each have a second equal temporal distance to the specified signal value (BW), and wherein the second temporal distance is greater than the first temporal distance.

10. Method according to any one of the previous claims, comprising

- detecting an event upon detecting a significant signal change on the basis of the output signal (AS), and

- controlling an actuator (AK) upon detection of the event.

11. Method according to any one of the previous claims, comprising

- acquiring the sensor signal (ZS) using a capacitive sensor.

12. Device for controlling an actuator by filtering a sensor signal, comprising

- a sensor (S) for acquiring an analogue sensor signal (ASI), in particular a capacitive sensor,
- a converter for providing the analogue sensor signal (ASI) in the form of a time-discrete sensor signal (ZS) as an input signal (ES),
- a computing unit (R) for receiving the input signal (ES), and
- an actuator (AK)

wherein the computing unit (R) is designed to carry out the following steps:

- generating an output signal (AS) via continuous filtering of the input signal (ES) using a time-discrete filter (ZF) in the time domain, wherein the filter (ZF) carries out the following filter steps for a respective value of the input signal (ES):

∘ comparing a specified signal value (BW) of a specified time index of the input signal (ES) with two further signal values (VW, NW) of the input signal (ES), wherein a first signal value (VW) of the two further signal values is temporally prior to the specified signal value (BW) and wherein a second signal value (NW) of the further signal values is temporally after the specified signal value (BW),

∘ replacing the specified signal value (BW) at the specific time index in the output signal (AS) by a new value in the event that the specific signal value (BW) lies outside the value interval spanned by the two further signal values (VW, NW),

wherein the computing unit (R) is designed to carry out the following steps:

- detecting an event by detecting a significant signal change on the basis of the output signal (AS), and

- outputting a control signal to the actuator (AK) upon detection of the event, **characterized in that**
- retaining the specific signal value (BW) unchanged at the specific time index in the event that the specific signal value (BW) lies within a value interval spanned by the two further signal values (VW, NW).

**13.** Device according to Claim 12,

wherein the control signal is a signal to activate the actuator (AK)
or wherein the control signal is a signal to stop the actuator (AK).

**Revendications**

**1.** Procédé de filtrage d'un signal de capteur, ledit procédé comprenant les étapes suivantes

- fournir un signal de capteur temporellement discret (ZS) comme signal d'entrée (ES),
- générer un signal de sortie (AS) par filtrage continu du signal d'entrée (ES) à l'aide d'un filtre temporellement discret (ZF) dans une plage de temps, lequel filtrage réalise les étapes de filtrage suivantes pour une valeur respective du signal d'entrée (ES) :

∘ comparer une valeur de signal déterminée (BW) d'un indice de temps déterminé du signal d'entrée (ES) à deux autres valeurs de signal (VW, NW) du signal d'entrée (ES), une première valeur de signal (VW) des deux autres valeurs de signal (WV, NW) étant située temporellement avant la valeur de signal déterminée (BW) et une deuxième valeur de signal (NW) des autres valeurs de signal (VW, NW) étant située temporellement après la valeur de signal déterminée (BVη,

- remplacer la valeur de signal déterminée (BW) à l'indice de temps déterminé dans le signal de sortie par une nouvelle valeur dans le cas où la valeur de signal déterminée (BW) est située à l'extérieur de l'intervalle de valeurs défini par les deux autres valeurs de signal (VW, NW),

**caractérisé par**

∘ la conservation inchangée de la valeur de signal déterminée (BW) à l'indice de temps déterminé dans le cas où la valeur de signal déterminée (BW) est située à l'intérieur d'un intervalle de valeurs défini par les deux autres valeurs de signal (VW, NW).

**2.** Procédé selon la revendication 1, **caractérisé en ce que** la nouvelle valeur (NW) est déterminée sur la base des deux autres valeurs de signal (VW, NW).

**3.** Procédé selon la revendication 2, **caractérisé en ce que** la nouvelle valeur (NEW) est déterminée comme étant la moyenne des deux autres valeurs de signal (WV, NW).

**4.** Procédé selon la revendication 2, **caractérisé en ce que** la nouvelle valeur (NEW) est choisie comme l'une des deux autres valeurs de signal (VW, NVη par rapport à laquelle la valeur déterminée (BW) présente un écart plus petit.

**5.** Procédé selon la revendication 2, **caractérisé en ce que** la nouvelle valeur (NW1) est déterminée en fonction

- de l'une des deux autres valeurs de signal (VW) pour laquelle la valeur déterminée (BW) présente un écart plus petit (AW1),
- et d'une différence (AW1) entre la valeur de signal déterminée (BW) et de l'une des deuxièmes autres valeurs de signal (VW).

**6.** Procédé selon la revendication 2, **caractérisé en ce que** la nouvelle valeur (NEW2) est déterminée en fonction

- de l'une des deux autres valeurs de signal (VW) pour laquelle la valeur déterminée (BW) présente un écart plus petit (AW1),
- et en outre d'une différence (AW1) entre la valeur de signal déterminée (BW) et l'une des deuxièmes autres valeurs de signal (VW)
- et en outre d'une valeur de correction (KO).

**7.** Procédé selon la revendication 1, les deux autres valeurs de signal (VW, NW) étant à la même distance temporelle de la valeur de signal déterminée (BW).

**8.** Procédé selon la revendication 1, comportant les étapes suivantes

- appliquer le filtre temporellement discret (ZF) de la revendication 1 au signal d'entrée (ES) dans un premier étage de filtrage afin de générer le signal de sortie (AS),
- fournir le signal de sortie (AS) du premier étage de filtrage (ZF) comme deuxième signal d'entrée (ES2) d'un deuxième étage de filtrage (ZF2),

- appliquer le filtre temporellement discret selon la revendication 1 au deuxième signal d'entrée (ES2) dans le deuxième étage de filtration (ZF2) afin de générer un deuxième signal de sortie (AS2).

9. Procédé selon la revendication 8,

dans le premier étage de filtrage (ZF) du filtre temporellement discret, les deux autres valeurs de signal (VW, NW) étant à une même première distance temporelle de la valeur de signal déterminée (BW),
dans le deuxième étage de filtrage (ZF2) du filtre temporellement discret, les deux autres valeurs de signal (VW, NW) étant à une même deuxième distance temporelle de la valeur de signal déterminée (BW),
et la deuxième distance temporelle étant supérieure à la première distance temporelle.

10. Procédé selon l'une des revendications précédentes, comprenant les étapes suivantes

- détecter un événement lors de la détection d'un changement de signal significatif sur la base du signal de sortie (AS) et
- commander un actionneur (AK) lorsque l'événement est détecté.

11. Procédé selon l'une des revendications précédentes, comprenant l'étape suivante :
détecter le signal de capteur (ZS) à l'aide d'un capteur capacitif.

12. Dispositif de commande d'un actionneur par filtrage d'un signal de capteur, ledit dispositif comprenant

- un capteur (S) destiné à détecter un signal de capteur analogique (ASI), en particulier un capteur capacitif,
- un convertisseur destiné à fournir le signal de capteur analogique (ASI) sous la forme d'un signal de capteur temporellement discret (ZS) en tant que signal d'entrée (ES),
- une unité de calcul (R) destinée à recevoir le signal d'entrée (ES) et
- un actionneur (AK)

l'unité de calcul (R) étant conçue pour effectuer les étapes suivantes :

- générer un signal de sortie (AS) par filtrage continu du signal d'entrée (ES) à l'aide d'un filtre temporellement discret (ZF) dans une plage de temps, le filtre (ZF) effectuant les étapes de filtrage suivantes pour une valeur respective du signal d'entrée (ES) :

◦ comparer une valeur de signal déterminée (BW) d'un indice de temps déterminé du signal d'entrée (ES) à deux autres valeurs de signal (VW, NW) du signal d'entrée (ES), une première valeur de signal (VW) de deux autres valeurs de signal étant située temporellement avant la valeur de signal déterminée (BW) et une deuxième valeur de signal (NW) des autres valeurs de signal étant située temporellement après la valeur de signal déterminée (BW),
◦ remplacer la valeur de signal déterminée (BW) à l'indice de temps déterminé dans le signal de sortie (AS) par une nouvelle valeur dans le cas où la valeur de signal déterminée (BW) est située à l'extérieur de l'intervalle de valeurs défini par les deux autres valeurs de signal (VW, NW),

l'unité de calcul (R) étant en outre conçue pour effectuer les étapes suivantes :

- détecter un événement par détection d'un changement de signal significatif sur la base du signal de sortie (AS) et
- délivrer un signal de commande à l'actionneur (AK) lorsque l'événement est détecté, **caractérisé en ce que**
- la conservation inchangée de la valeur de signal déterminée (BW) à l'indice de temps déterminé dans le cas où la valeur de signal déterminé (BW) est située dans un intervalle de valeurs défini par les deux autres valeurs de signal (VW, NW).

13. Dispositif selon la revendication 12,
le signal de commande étant un signal d'activation de l'actionneur (AK) ou le signal de commande étant un signal d'arrêt de l'actionneur (AK).

**FIG. 1**

**FIG. 2**

**FIG. 3**

## FIG. 4

ZF

ES

ES(k)

VG

$Z^{-1}$ → $Z^{-1}$ → $Z^{-1}$ → $Z^{-1}$ → $Z^{-1}$ → $Z^{-1}$

NW

BW

VW

BS

AS

AS(k)

## FIG. 5

BS

NW

VW

BW

IB

WI

?

CS

N

J

BW, BWA

NEW, BWA

**FIG. 6a**

ES

ZF

AS, ES2

ZF2

AS2

**FIG. 6b**

AS

S4

S5

ST

**FIG. 7**

**FIG. 8**

**FIG. 9**

EP 4 202 372 B1

# FIG. 10a

# FIG. 10b

EP 4 202 372 B1

**FIG. 11a**

**FIG. 11b**

FIG. 12a

FIG. 12b

## FIG. 13a

## FIG. 13b

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1489742 A2

**In der Beschreibung aufgeführte Nicht-Patentliteratur**

- **K.-D. KAMMEYER ; K. KROSCHEL.** Digitale Signalverarbeitung - Filterung und Spektralanalyse mit MATLAB®-Übungen. Springer Vieweg, 21. April 2018

- **A. MERTINS.** Signaltheorie: Grundlagen der Signalbeschreibung, Filterbänke, Wavelets, Zeit-FrequenzAnalyse, Parameter- und Signalschätzung. Springer Vieweg, 2020, vol. 4